# EUROPÄISCHE PATENTSCHRIFT

(11) **EP 2 188 405 B1**
(45) Veröffentlichungstag und Bekanntmachung des Hinweises auf die Patenterteilung: **14.08.2013**
(21) Anmeldenummer: 08748374.9
(22) Anmeldetag: 30.05.2008
(51) Int. Cl.: C23C 14/02, C23C 14/08, C23C 14/18, C23C 16/02, C23C 16/26, C23C 8/02, B81C 1/00, B82Y 30/00

(54) **VERFAHREN ZUR HERSTELLUNG EINER METALLOXID-BESCHICHTETEN WERKSTÜCKOBERFLÄCHE MIT VORGEBBAREM HYDROPHOBEN VERHALTEN**
METHOD FOR PRODUCING A METAL-OXIDE-COATED WORKPIECE SURFACE WITH PREDETERMINABLE HYDROPHOBIC BEHAVIOUR
PROCÉDÉ DE PRODUCTION D'UNE SURFACE DE PIÈCE REVÊTUE D'OXYDE MÉTALLIQUE AYANT UN COMPORTEMENT HYDROPHOBE PRÉDÉFINISSABLE

(30) Priorität: 13.08.2007 CH 12722007
(43) Veröffentlichungstag der Anmeldung: 26.05.2010
(73) Patentinhaber: Incoat GmbH, 8212 Neuhausen am Rheinfall (CH)
(72) Erfinder: MOSER, Eva, Maria, CH-8224 Löhningen (CH)
(74) Vertreter: PATWIL AG
(86) Internationale Anmeldenummer: PCT/CH2008/000244
(87) Internationale Veröffentlichungsnummer: WO 2009/021340

(56) Entgegenhaltungen:
- JP-A- 2006 255 701
- US-A1- 2006 039 096
- YAMASHITA H ET AL: "Coating of TiO2 photocatalysts on super-hydrophobic porous teflon membrane by an ion assisted deposition method and their self-cleaning performance" NUCLEAR INSTRUMENTS & METHODS IN PHYSICS RESEARCH, SECTION - B: BEAM INTERACTIONS WITH MATERIALS AND ATOMS, ELSEVIER, AMSTERDAM, NL, Bd. 206, Mai 2003 (2003-05), Seiten 898-901, XP004425953 ISSN: 0168-583X

## Beschreibung

Die Erfindung bezieht sich auf ein Verfahren zur Herstellung einer Metalloxidbeschichteten Werkstückoberfläche, mit vorgebbarem hydrophoben Verhalten mit einem Wasserkontaktwinkel (WCA) von grösser als 90° und einer auf Keime wie Bakterien, Viren, Pilzen und Mikroben keimtötend wirkenden Werkstückoberfläche, sowie auf ein Werkstück.

Die Herstellung von keramischen Dünnschichten wie die Metalloxide SiOₓ, AlOₓ, ZnOₓ, ITO, TiOₓ und deren Hydroxide enthaltende Verbindungen auf diversen Materialien wird industriell mit verschiedenen PVD (Physical Vapour Deposition), CVD (Chemical Vapour Deposition) und PE-CVD (Plasma Enhanced Chemical Vapour Deposition) Verfahren realisiert und ist in zahlreichen Fachbüchern beschrieben, wie in "Traité des matériaux", 4. Analyse et technologie des surfaces; Hans Jörg Mathieu, Erich Bergmann, René Gras; 2003; ISBN 2-88074-454-7. Ebenfalls bekannt ist die sekundäre Bildung von Karbonaten an den Metalloxid-Oberflächen infolge von Reaktionen mit der Umgebung. Die keimtötende, detoxifizierende und selbstreinigende Wirkung einer photokatalytisch aktiven, hydrophilen Titandioxid-Oberfläche ist in zahlreichen Veröffentlichungen beschrieben und wird auf die Redoxreaktionen in der Bandlücke des Halbleiters Titandioxids zurückgeführt, die durch Lichtexposition hervorgerufen werden. Im Review von O. Carp, C.L. Huisman, A. Reller, Prog. Solid State Chem. 2004, vol. 32, N° 1-2 pp. 3-177 sind die Herstellungsmethoden sowie die drei Anwendungsgebiete (Erzeugung von Elektrizität in Solarzellen, Erzeugung sowie Zerstörung von spezifischen Substanzen aufgrund von chemischen Reaktionen und der photoinduzierten Superhydrophilie) zusammengestellt. In der Literatur werden bis anhin ausschliesslich Titandioxid-Oberflächen mit hydrophilem Verhalten beschrieben.

Ebenfalls bekannt ist die keimtötende (desinfizierende, anti-mikrobielle, bakterizide, viruzide, fungizide) Wirkung von Werkstückoberflächen, welche mit Silber oder anderen Metallen beschichtet sind. Als Stand der Technik für die Silberbeschichtung von Textilien wird auf den Artikel von H.J. Lee, S.Y. Yeo and S.H. Jeong in Journal of Material Science 2003 vol. 38, No 10, pp. 2199-2204, für die kolloidale Silber Beschichtung von Titandioxid-Partikeln auf den Artikel von J. Keleher, J. Bashant, N. Heldt, L. Johnson, Y. Li in World Journal of Microbiology and Biotechnology 2002, Vol. 10, No 2, pp. 133-139 und für die photolytische Silber-Beschichtung von Titandioxid auf den Artikel von Mitsuyoshi Machida, Keiichiro Norimoto, Tamon Kimura in Journal of the American Ceramic Society 2005, 88 (1), 95-100 verwiesen.

Das Benetzungsverhalten von Flüssigkeiten - wie insbesondere von Wasser - an Materialoberflächen spielt bei vielen Anwendungen eine wichtige Rolle. Unter Benetzung wird der Grad des haftenden Kontakts von Flüssigkeiten an Oberflächen, insbesondere an Festkörpern verstanden. Es bezeichnet die Fähigkeit von Flüssigkeiten, sich auf einer Oberfläche auszubreiten. Ein wichtiger Fall ist hierbei das hydrophobe Verhalten einer Oberfläche, also das wasserabweisende Verhalten, bei welchem das Wasser an der Oberfläche abgestossen wird und sich dadurch beispielsweise Tropfen bilden. Oberflächen werden als nicht benetzbar, also hydrophob bezeichnet, wenn der Kontaktwinkel > 90° beträgt. Der Gegensatz dazu ist das hydrophile Verhalten, wodurch an der Oberfläche Wasser gut angenommen wird. Dieses Benetzungsverhalten wird gemessen und definiert durch den sogenannten Wasserkontaktwinkel (WCA). Je besser die Benetzbarkeit ist, umso kleiner ist der bei der Benetzung auftretende Kontaktwinkel und beträgt < 90°. Die Definition stammt aus dem Review von Huan Liu, Jin Zhai and Lei Jiang, Soft Matter, 2006, 2, 811-821.

US2006/0039096 offenbart ein Verfahren zur Herstellung einer hydrophoben Werkstückoberfläche durch Abscheidung von erst einer Kohlenstoffschicht und danach einer 10-50 nm TiO2-Schicht aus einer titan- und sauerstoffhaltigen Plasmaentladung auf einem Substrat in einer Vakuumkammer.

Keramische, metalloxidhaltige Oberflächen sind hydrophil. Einer der Nachteile der hydrophilen Oberfläche ist die Tropfenbildung von Flüssigkeiten. Die Werkstückoberfläche ist deshalb lange feucht und trocknet nicht ab. Dieses Kondensationsverhalten kann auch den Abtransport von Flüssigkeiten und Verunreinigungen sowie die problemlose Reinigung der Oberfläche behindern. Als Folge davon können Flüssigkeiten und Füllgut nicht restlos überführt werden, das Wachstum von Keimen sowie die Korrosion bei Metallen sind begünstigt.

Es ist Aufgabe der vorliegenden Erfindung, die Nachteile des Standes der Technik zu beseitigen. Insbesondere ist es Aufgabe der vorliegenden Erfindung, ein Verfahren zu realisieren welches ermöglicht, Materialoberflächen bestehend aus Kunststoffen, Naturmaterialien und Metallen derart zu behandeln, dass eine metalloxidhaltig beschichtete Werkstückoberfläche mit einem gewünschten Grad eines hydrophoben keimtötend wirkenden Verhaltens entsteht. Zusätzlich ist es Aufgabe der vorliegenden Erfindung, an sich bereits bekannte und bewährte Grundprozesse verwenden zu können, welche eine wirtschaftliche Herstellbarkeit der Produkte ermöglicht.

Durch die Implantation von metallhaltigen Nanopartikeln an der Oberfläche der Metalloxid-Deckschicht wird eine keimtötende und gegebenenfalls anti-statische Schutzwirkung erzielt. Das erfindungsgemäss verwendete Plasmaverfahren für die Herstellung der Nanopartikel ermöglicht eine weitgehende Immobilisierung der Nanopartikel und damit eine Steuerung der Dosierung der Freisetzung der MetallIonen und der Minimierung des Risikos von mobilen Nanopartikeln. Insbesondere im Medizinalbereich kann die keimtötende Wirkung der Metall-Ionen - welche ohne Lichtexposition erfolgt - von grosser Bedeutung sein.

Im Spezialfall der keramischen Dünnschicht Titandioxid - insbesondere bei Vorliegen der Modifikation Anatas - ist die keimtötende Wirkung dank der photokatalytische Aktivität bei Einwirkung von Licht auch ohne freisetzende Metall-Ionen vorhanden. Durch die Implantation von Metallpartikeln in katalytische Dünnschichtsysteme wird einerseits die katalytische Aktivität und elektrische Leitfähigkeit signifikant erhöht, andererseits erfolgt die keimtötende Wirkung der Werkstückoberfläche unabhängig von der Lichtexposition.

Bei allen Varianten wird der inhärent hydrophilen Metalloxid-Oberfläche ein hydrophobes Verhalten auferzwungen, indem die Werkstückoberfläche mikrostrukturiert wird. Das veränderte Kondensationsverhalten bewirkt einen besseren Transfer von Flüssigkeiten und Füllgut sowie eine bessere Reinigung und Trocknung der Werkstückoberfläche.

Bei der zweiten Variante wird der hydrophobe Effekt durch das Vorliegen einer Nanostrukturierung der Substratoberfläche etwas abgeschwächt, doch wird andererseits die katalytische Aktivität der Titandioxid - oder Zinkoxidschicht verstärkt, was für bestimmte Anwendungen vorteilhaft ist. Das Resultat ist in jedem Fall eine sich aktiv keimtötende, detoxifizierende und selbstreinigende Werkstückoberfläche, welche insbesondere im Medizinal- und Pharmabereich von Bedeutung ist. Durch die Kombination von den bis zu drei synergetisch wirkenden Modifizierungen (Mikrostruktur, metallhaltige Nanopartikel, Titandioxid) wird eine nachhaltige, sich dauerhaft aktiv selbstreinigende, keimtötende Werkstückoberfläche erhalten. Die Abstimmung dieser Kombinationselemente ist für die jeweilige Anwendung entscheidend, um einen optimalen Effekt zu erhalten.

Diese Aufgabe wird erfindungsgemäss durch die Merkmale der Ansprüche 1, 14 und 15 gelöst. Weitere vorteilhafte Ausführungsformen beinhalten die abhängigen Patentansprüche. Erfindungsgemäss soll ein Werkstück mit einer metalloxidhaltigen Dünnschicht beschichtet werden, welche ein mit wählbarem Grad hydrophobes und keimtötendes Verhalten aufweist. Die Oberfläche eines Substratmaterials wird deshalb mindestens in Teilbereichen durch mechanisches Prägen mit einer Mikrostruktur versehen und anschliessend beschichtet. Für die Erzeugung der Mikrostruktur soll das Werkstück aus prägbaren Material bestehen, wie beispielsweise aus einem Polymer, vorzugsweise einem Thermoplasten wie beispielsweise Polypropylen oder einem Metall, vorzugsweise einem duktilen Metall, wie Kupfer, Aluminium, Stahl und deren Legierungen. Bei einem Metall können auch andere Verfahren wie Kugelstrahlen oder Elektrokorrosion eingesetzt werden.

Die Plasmabehandlung erfolgt vorzugsweise in einem abgeschlossenen System, bei dem die eingeleiteten Prozessgase mit einer Vakuumpumpe abgepumpt werden. Der jeweilige Arbeitsdruckbereich ist in einem grossen Bereich einstellbar und kann Atmosphärendruck erreichen. Die unterschiedlichen Prozesse ermöglichen die gezielte Erstellung von Oberflächen mit dem gewünschten Grad der Benetzbarkeit.

Zur Erzeugung einer Werkstückoberfläche mit vorgebbarem hydrophoben Verhalten mit einem Wasserkontaktwinkel (WCA) von grösser als 90° werden erfindungsgemäss in der ersten Variante folgende Verfahrensschritte durchgeführt:
- es wird ein Substrat verwendet, in welches mindestens in Teilbereichen mechanisch eine linienartige oder gitterartige Mikrostruktur mit Vertiefungen oder Erhöhungen eingeprägt wird, die aus einer Vielzahl von aneinander hängenden Strukturelementen gebildet wird, deren einzelne Ausdehnungen im Bereich von 3 µm bis 50 µm liegen, und dass zwischen den angrenzenden Strukturelementen grabenförmige Vertiefungen oder Erhöhungen mit einer Tiefe im Bereich von 1 µm bis 10 µm - vorzugsweise 3 µm bis 7 µm - ausgebildet werden, welche um die Strukturelemente mit einer Breite im Bereich von 3 µm bis 11 µm - vorzugsweise 5 µm bis 7 µm - angeordnet sind;
- nach der Mikrostrukturierung wird mindestens eine Deckschicht in einer Vakuumkammer aus einer Plasmaentladung mindestens in Teilbereichen auf das Substrat abgeschieden, die mindestens ein metallhaltiges und ein sauerstoffhaltiges Gas und/oder eine metalloxidhaltige Verbindung enthält eine Schichtdicke im Bereich von 5.0 bis 500 nm - vorzugsweise 10 bis 300 nm aufweist -,

Zur Erzeugung einer polymeren Werkstückoberfläche mit vorgebbarem hydrophoben Verhalten mit einem Wasserkontaktwinkel (WCA) von grösser als 90° sowie einer keimtötend wirkenden Werkstückoberfläche, werden in der zweiten Variante folgende Verfahrensschritte durchgeführt:
- es wird ein Substrat verwendet, welches mindestens an der Oberfläche aus Kunststoff besteht und in diese Kunststoffoberfläche wird mindestens in Teilbereichen mechanisch eine linienartige oder gitterartige Mikrostruktur mit Vertiefungen oder Erhöhungen eingeprägt, die aus einer Vielzahl von aneinander hängenden Strukturelementen gebildet wird, deren einzelne Ausdehnungen im Bereich von 3 µm bis 50 µm liegen, und dass zwischen den angrenzenden Strukturelementen grabenförmige Vertiefungen oder Erhöhungen mit einer Tiefe im Bereich von 1 µm bis 10 µm, vorzugsweise 3 µm bis 7 µm ausgebildet werden, welche um die Strukturelemente mit einer Breite im Bereich von 3 µm bis 11 µm - vorzugsweise 5 µm bis 7 µm - angeordnet sind;
- nach der mechanischen Strukturierung wird das Substrat in einer Vakuumkammer in mindestens zwei Schritten mit einer Plasmaentladung mindestens in Teilbereichen behandelt, wobei bei einem ersten Schritt dem Plasma mindestens Sauerstoff oder Wasserstoff zugeführt wird zur chemischen Ätzung der Substratoberfläche und bei dem darauf folgenden zweiten Schritt dem Plasma mindestens ein Edelgas beigefügt wird zur Ionenätzung der Substratoberfläche;
- nach der Plasmabehandlung wird eine kohlenwasserstoffhaltige oder siliziumoxidhaltige Schutzschicht in einer Vakuumkammer aus einer Plasmaentladung auf das Substrat mindestens in Teilbereichen abgeschieden, welcher mindestens ein kohlenwasserstoffhaltiges oder mindestens ein siliziumhaltiges und sauerstoffhaltiges Gas zugeführt wird, und dass eine Schichtdicke erzeugt wird, welche im Bereich von 2.0 nm bis 70 nm liegt - vorzugsweise im Bereich von 5.0 nm bis 30 nm-;
- in einem weiteren Schritt wird mindestens eine Deckschicht in einer Vakuumkammer aus einer Plasmaentladung mindestens in Teilbereichen auf das Substrat abgeschieden, die mindestens ein metallhaltiges und ein sauerstoffhaltiges Gas und/oder eine metalloxidhaltige Verbindung enthält, eine Schichtdicke im Bereich von 5.0 bis 100 nm, - vorzugsweise 10 bis 50 nm - aufweist.

Zur Erzeugung einer Werkstückoberfläche mit vorgebbarem hydrophoben Verhalten mit einem Wasserkontaktwinkel (WCA) von grösser als 90° sowie einer keimtötend wirkenden Werkstückoberfläche, werden in der dritten Variante folgende Verfahrensschritte durchgeführt:
- es wird ein Substrat verwendet, in welches mindestens in Teilbereichen mechanisch eine linienartige oder gitterartige Mikrostruktur mit Vertiefungen oder Erhöhungen eingeprägt wird, die aus einer Vielzahl von aneinander hängenden Strukturelementen gebildet wird, deren einzelne Ausdehnungen im Bereich von 3 µm bis 50 µm liegen, und dass zwischen den angrenzenden Strukturelementen grabenförmige Vertiefungen oder Erhöhungen mit einer Tiefe im Bereich von 1 µm bis 10 µm - vorzugsweise 3 µm bis 7 µm - ausgebildet werden, welche um die Strukturelemente mit einer Breite im Bereich von 3 µm bis 11 µm - vorzugsweise 5 µm bis 7 µm - angeordnet sind;
- nach der Plasmabehandlung wird eine kohlenwasserstoffhaltige oder siliziumoxidhaltige Schutzschicht in einer Vakuumkammer aus einer Plasmaentladung auf das Substrat mindestens in Teilbereichen abgeschieden, welcher mindestens ein kohlenwasserstoffhaltiges oder mindestens ein silizium- und oxidhaltiges Gas zugeführt wird, und dass eine Schichtdicke erzeugt wird, welche im Bereich von 2.0 nm bis 500 nm liegt, - vorzugsweise im Bereich von 5.0 nm bis 100 nm - ;
- in einem weiteren Schritt wird mindestens eine Deckschicht in einer Vakuumkammer aus einer Plasmaentladung mindestens in Teilbereichen auf das Substrat abgeschieden, welcher ein metallhaltiges und sauerstoffhaltiges Gas und/oder eine metalloxidhaltige Verbindung zugeführt wird, und dass eine Schichtdicke erzeugt wird, welche im Bereich von 5.0 nm bis 500 nm - vorzugsweise im Bereich von 10 nm - 300 nm liegt.
- in einem weiteren Schritt werden mindestens eine Art von metallhaltigen Nanopartikel in einer Vakuumkammer aus einer Plasmaentladung mindestens in Teilbereichen auf das Substrat abgeschieden, welcher mindestens ein metallhaltiges Gas zugeführt wird, und dass diese eine Partikelgrösse von 1.0 bis 70 nm Durchmesser - vorzugsweise 3.0 bis 20 nm - aufweisen.

Das Substrat kann organischer Natur (polymerartige oder natürliche Materialien) oder anorganischer Natur (Metalle, Legierungen, Keramik, Glas, etc.) sein, oder aus Kombinationen daraus bestehen. Vorzugsweise werden als Polymere Thermoplasten verwendet, bei den natürlichen Materialien sind Objekte aus Papier, Maisstärke, Baumwolle oder Viskose vorstellbar. Im Falle von anorganischen Materialien handelt es sich vorzugsweise um metallische Substratoberflächen. Vorstellbar sind insbesondere leicht verformbare Substrate, wie beispielsweise Aluminiumfolien, mit Metall beschichtete Werkstücke, etc. Beim Substrat kann es sich um zwei oder dreidimensionale Objekte handeln, wie eine Folie, eine Platte, Gewebe, Membran, Textil, Faden, Rolle, Schlauch, Gehäuse, Flasche, Behälter, etc. Die Mikrostruktur wird mit Vorteil in das Substratmaterial mechanisch an der Oberfläche eingeprägt. Ätzverfahren, beispielsweise elektrochemische, elektrokorrosive oder chemische sind auch möglich, aber teilweise weniger wirtschaftlich. Das mechanische Prägen kann auf bekannte Art erfolgen, beispielsweise mit Stempelpressen oder Walzen. Für Kunststoffsubstrate eignet sich das Heissprägen. Die Strukturierung erfolgt mit Vorteil mit sich periodisch wiederholenden gleichen Strukturelementen, ist mit Vorteil linienartig oder gitterartig ausgebildet und sollte mindestens in Teilbereichen an einer Substratoberfläche erfolgen. Besonders geeignet als Kunststoff sind Thermoplaste und vorzugsweise Polypropylen.

Die kohlenwasserstoffhaltige Schutzschicht dient der Haftvermittlung und/oder als Diffusionssperre sowie bei Einbau von metallhaltigen Nanopartikein dem Korrosionsschutz von metallischen Oberflächen. Ganz allgemein schützt die Schutzschicht vor Umgebungseinflüssen und ermöglicht ein stabiles Verhalten der Oberfläche, derart dass Degradationen durch die katalytische Wirkung der Deckschicht oder Korrosion des Substrates über mehrere Monate bis Jahre im wesentlichen vermieden werden oder zumindest äusserst gering gehalten werden können. Die Schichtdicke der kohlenwasserstoffhaltigen oder siliziumoxidhaltigen Schutzschicht beträgt 2.0 nm bis 200 nm, vorzugsweise 5.0 nm bis 100 nm, und im Falle von transparenten, farblosen Beschichtungen 5.0 nm bis 50 nm.

Die Korrosion der metallischen Substratoberfläche wird einerseits durch die Diffusionssperre der Schutzschicht, andererseits durch die Implantation von mindestens einer Art von metallhaltigen Nanopartikeln von 5.0 at% bis 50 at% - vorzugsweise von 5.0 at% bis 20 at% - zusätzlich verhindert, indem das elektrochemische Potential des metallischen Substrates modifiziert wird. Dieser kathodische oder anodische Schutz durch metallhaltige Nanopartikel ist in der Europäischen Patentschrift EP 1 251 975 B1 beschrieben. Durch die Kombination mit dem hydrophoben Verhalten der beschichteten Oberfläche trocknet die Werkstückoberfläche schneller ab. Als Folge davon wird der Korrosionsschutz zusätzlich erhöht. Zusätzlich kann die metalloxidhaltige Deckschicht dem Werkstück Kratzschutz verleihen.

Durch die Implantation von metallhaltigen Nanopartikeln kann die elektrische Leitfähigkeit an der metalloxidbeschichteten Oberfläche erhöht werden, bei einem isolierenden Werkstück wird dadurch der Anti-Statik Effekt erzeugt.

In den drei Ausbildungen ist es möglich, sowohl zwischen der Substratoberfläche, der Schutzschicht und der Deckschicht weitere Prozessschritte oder Beschichtungen vorzunehmen, solange die Mikrostruktur und gegebenenfalls die Nanostruktur an der Werkstückoberfläche wirksam abgebildet werden. Für diese Prozessschritte können selbstverständlich beliebige Methoden verwendet werden. Die hydrophobe Wirkung kann gegebenenfalls mit einer rauhen Werkstückoberfläche verstärkt werden, wie in dem Artikel von S. Shibuichi et al., Journal of Colloid and Interface Science 208, 287-294 (1998) beschrieben ist.

Hinzu kommt, dass alle beschriebenen Behandlungen des Substrats (1) ganzflächig oder nur in flächigen Teilbereichen erfolgen können.

Die Erfindung wird anschliessend beispielsweise anhand von schematischen Figu ren erläutert:
- Fig. 1: eine schematische Darstellung einer Produktionseinrichtung zur Herstellung einer Werkstückoberfläche mit hydrophobem Verhalten;
- Fig. 2: im Querschnitt ein Substrat mit mikrostrukturierter Oberfläche für die erfindungsgemässe Ausbildung;
- Fig. 3: im Querschnitt das Substrat nach Figur 2 mit überlagerter nanostrukturierter Oberfläche
- Fig. 4: im Querschnitt das Substrat nach Figur 3 mit einer Schutzschicht auf der mikro- und nanostrukturierten Fläche;
- Fig. 5: im Querschnitt das Substrat nach Figur 4 mit auf der Schutzschicht abgelegter Deckschicht, die Werkstückoberfläche mit hydrophobem Verhalten;
- Fig. 6: ein Beispiel Schichtaufbaus mit Nanostrukturierung an einer Kunststoff - Substratoberfläche;
- Fig. 7a: im Querschnitt ein Substrat mit mikrostrukturierter Oberfläche und mit darauf abgelegter kohlenwasserstoffhaltiger Schutzschicht, welche metallhaltige Nanopartikel enthält und einer Deckschicht mit eingebetteten Nanopartikeln;
- Fig. 7b: ein Ausschnitt von Fig. 7a, vergrössert
- Fig. 8: in der Aufsicht eine Darstellung einer mikrostrukturierten Substratobertläche mit verschieden grossen und verschieden geformte Strukturelementen, welche Vertiefungen oder Erhöhungen darstellen können;
- Fig.9: in der Aufsicht ein Beispiel einer mikrostrukturierten Substratoberfläche mit quadratisch gleich grossen und gegeneinander versetzten Strukturelementen, welche Vertiefungen oder Erhöhungen darstellen können;
- Fig.10: in der Aufsicht ein weiteres Beispiel einer mikrostrukturierten Substratoberfläche mit pyramidalen, gleich grossen, gegeneinander nicht versetzten Strukturelementen, welche Vertiefungen oder Erhöhungen darstellen können;
- Fig.11: in der Aufsicht ein weiteres Beispiel einer mikrostrukturierten Substratoberfläche mit mehreckigen Strukturelementen, welche Vertiefungen oder Erhöhungen darstellen können;
- Fig.12: in der Aufsicht ein Beispiel einer nanostrukturierten Substratoberfläche.

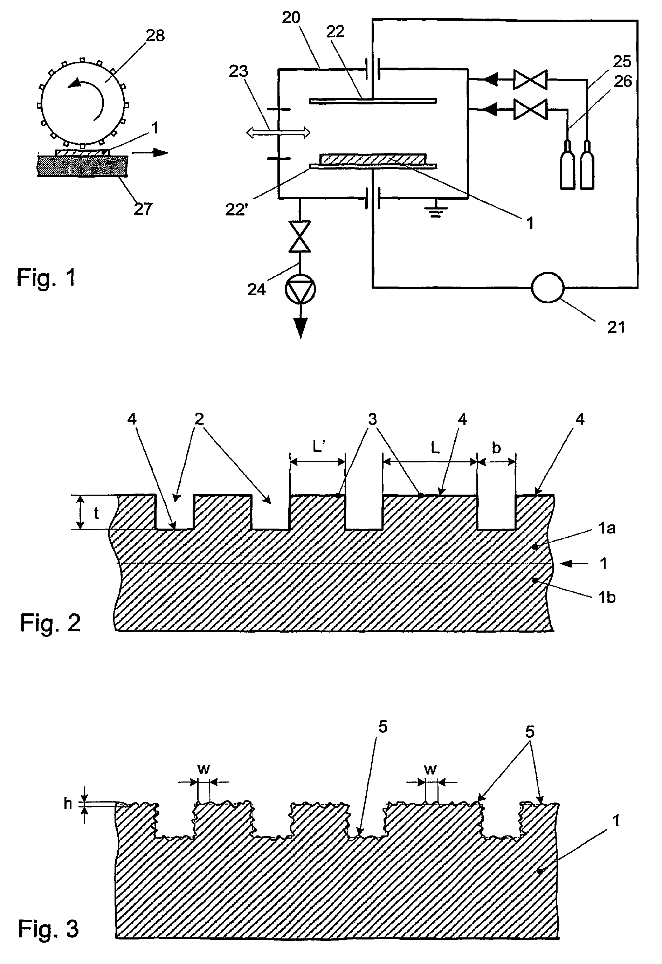

Zur Herstellung eines Werkstückes 10 mit dem gewünschten Grad eines hydrophoben Verhaltens wird zuerst das Substrat 1 an dessen Oberfläche durch vorzugsweise mechanisches Prägen mit einer Mikrostruktur versehen und danach in einer Vakuumanlage 20 plasmabehandelt und / oder beschichtet, wie dies schematisch in Figur 1 dargestellt ist. Die Prägung wird mit bekannten Verfahren vorgenommen, indem in die Substratoberfläche 4 des auf einem Substratträger 27 liegenden Substrates 1 mit einem Prägewerkzeug 27, wie einem Prägestempel oder einer Prägewalze, die vorgesehenen Strukturelemente 3 eingeprägt bzw. eingedrückt werden.

Es können mit Vorteil auch bandförmige Substrate, beispielsweise Metallfolien im Durchlaufverfahren bearbeitet werden. Danach werden die weiteren Bearbeitungsschritte in einer Vakuumanlage 20 vorgenommen. Das Substrat 1 wird in die Vakuumanlage 20 durch eine Schleuse 23 transportiert und dort auf einem Träger oder direkt auf einer Elektrode 22' abgelegt. Die Vakuumanlage wird über ein Pumpsystem 24 evakuiert. Das Arbeitsgas und allenfalls ein Trägergas wie vorzugsweise inerte Gase, wie beispielsweise Argon oder Helium, werden über Gaseinlassysteme 25, 26 in die Vakuumkammer eingelassen mit dem gewünschten Gasfluss und Arbeitsdruck in der Kammer. Eine zweite Elektrode 22 ist gegenüber der ersten Elektrode 22' angeordnet und beide Elektroden sind mit einer Stromversorgung 21 zur Erzeugung des Plasmas verbunden. Die Plasmaentladung kann bei einzelnen Verfahrensschritten mit einer Gleichstrom (DC) - Stromversorgung 21 gespiesen werden, solange Materialien beteiligt sind, die mindestens eine gewisse elektrische Leitfähigkeit aufweisen. Bei weniger gut leitenden Materialien oder bei dielektrischen Materialien, wie Kunststoffen werden mit Vorteil DC- gepulste Speisungen oder Wechselstrom (AC) - Speisungen 21 eingesetzt. Je nach Dicke und Leitfähigkeit der am Prozess beteiligten Materialien wird die Höhe der DC - Pulsfrequenz oder der AC - Frequenz gewählt. Bei DC- Pulsen können mit Vorteil Frequenzen von 50 kHz bis 500 kHz eingesetzt werden, sowohl mit unipolaren, wie auch bipolaren Pulsen. Bipolare Pulse können asymmetrisch sein und nur einen geringen negativen oder positiven Anteil aufweisen, wobei die Einschaltzeit grösser als die Ausschaltzeit zu wählen ist. Bei der AC - Speisung können Mittelfrequenzen von 10 kHz bis 1.0 MHz eingesetzt werden. Oft verwendete Frequenzen für die AC Speisung liegen im RF - Bereich welcher einen Bereich von 1.0 MHz bis etwa 1.0 GHz einschliesst. In gewissen Fällen ist auch der Einsatz von Mikrowellen möglich, mit Frequenzen die über 1.0 GHz liegen. Gegebenenfalls ist es vorteilhaft, magnetfeldunterstütze Plasmareaktoren zu verwenden.

Weitere Beschichtungsquellen, wie Zerstäubungsquellen, vorzugsweise Magnetronquellen, können vorgesehen werden, um zusätzliche Schichten auch mit anderen Methoden als mit der erwähnten Plasmaabscheidung (PECVD) erstellen zu können. Für metalloxidhaltige Schichten, wie beispielsweise TiOₓ wird hierbei vorzugsweise ein reaktiver Prozess verwendet, bei dem das zu zerstäubende Material Titan enthält und Sauerstoff als Arbeitsgas 26 und ein Trägergas 25, beispielsweise Argon in die Prozesskammer 20 eingeführt wird. Auch die Zerstäubungsquellen werden mit DC- oder AC - Speisungen betrieben, entsprechend der vorerwähnten Angaben. Die einzelnen Schritte der Vakuumprozesse können auch in verschiedenen Anlagen durchgeführt werden, sie werden aber mit Vorteil alle in derselben Anlage durchgeführt oder in Mehrkammersystemen, wenn unterschiedliche Prozessbedingungen notwendig sind oder auch eine Vollautomatisierung vorgesehen ist.

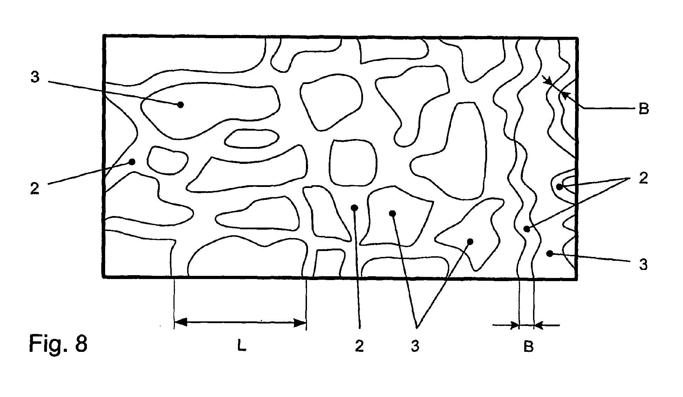

Anhand der Figuren 2 bis 6 werden nachfolgend die einzelnen Schritte zur Erzeugung eines Werkstückes 10 für die erste Variante der Erfindung beschrieben. Bei der zweiten Variante wird eine Nanostruktur 5 direkt aus einer Kunststoff Substratoberfläche erstellt und einer Mikrostruktur 2, 3 an der Substratoberfläche 4 überlagert. In Figur 2 ist schematisch und im Querschnitt und in Figur 8 in der Aufsicht dargestellt, wie in einem ersten Schritt (a), eine Mikrostruktur in die Oberfläche des Substrates 1 mechanisch geprägt ist, um eine mindestens in Teilbereichen mikrostrukturierte Oberfläche 4 zu erhalten. Das Substrat 1 kann hierbei aus verschiedenen Materialien bestehen. Das Substrat 1 enthält beispielsweise im unteren Bereich ein anderes Material 1b, als der obere Bereich 1 a, der an die Substratoberfläche grenzt. Der obere Teil besteht aus einem Polymer oder Metall 1 a, und ist derjenige Materialteil, in den die Mikrostruktur 2, 3 eingeprägt ist. Als Kunststoffe sind Thermoplasten, insbesondere Polyolephine geeignet. Die Mikrostruktur besteht aus einer linienartigen oder gitterartigen Struktur mit mechanisch eingeprägten Vertiefungen oder Erhöhungen 2, die aus einer Vielzahl von aneinander hängenden Strukturelementen 3 gebildet wird, deren einzelne Ausdehnungen I, I' im Bereich von 3 µm bis 50 µm liegen. Zwischen den angrenzenden Strukturelementen 3 sind die Vertiefungen oder Erhöhungen 2 grabenförmig ausgebildet. Diese Vertiefungen oder Erhöhungen 2 können auch Unterbrüche im Umfang aufweisen. Die Linien müssen zudem nicht gerade sein, sondern können eine zickzackige oder kurvige Form aufweisen.

Die Tiefe t, der grabenförmigen Vertiefungen oder Erhöhungen 2 liegt im Bereich von 1 µm bis 10 µm, vorzugsweise 3 µm bis 7 µm. Die Vertiefungen oder Erhöhungen können bei einem Werkstück unterschiedlich ausgeprägt sein. Die Querschnittsform der Vertiefungen oder Erhöhungen 2 ist nicht besonders wichtig und kann nach praktischen, herstellungstechnischen Gesichtspunkten gewählt werden.

Die Breite b der grabenförmigen Vertiefungen oder Erhöhungen 2 an der Substratoberfläche 4 liegt im Bereich von 3 µm bis 11 µm, vorzugsweise bei 5 µm bis 7 µm. Die Abmessungen I, I' der Strukturelemente 3, also die längste Ausdehnung I und die kleinste Ausdehnung l' der Fläche des Strukturelementes 3 liegen innerhalb des Bereiches von 3 µm bis 50 µm.

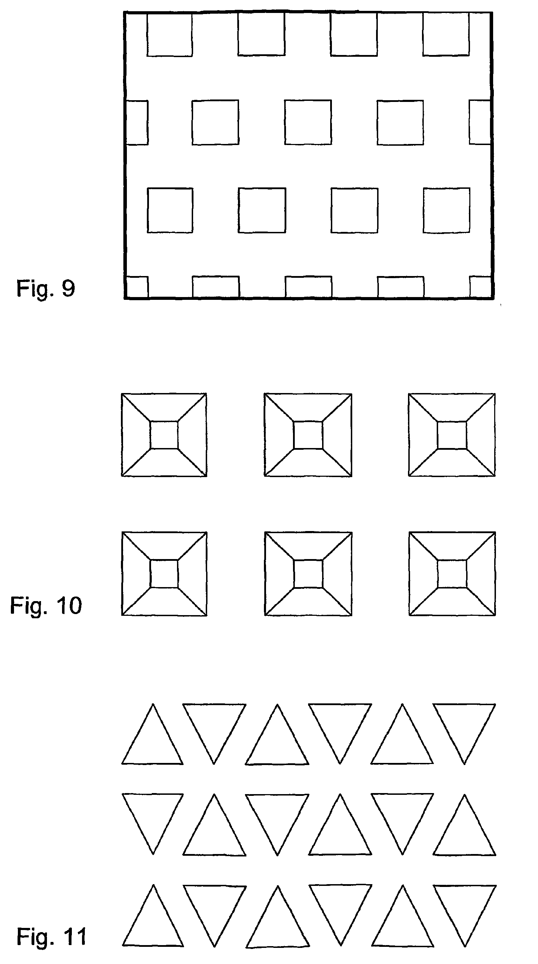

Die Strukturelemente können verschiedene Formen und Grössen aufweisen, wie dies in den Figuren 2 und 8 dargestellt ist. Für die praktische Realisierung sind periodisch, sich wiederholende Muster von Vorteil, wie sie beispielsweise in den schematischen Figuren 9 bis 11 in der Aufsicht dargestellt sind. Figur 9 zeigt eine Mikrostruktur mit periodisch angeordneten rechteckigen oder quadratischen Strukturelementen 3 mit gegeneinander in einer Linie versetzter Anordnung. In Figur 10 ist ein Beispiel mit quadratischen Strukturelementen 3 in nicht versetzter Anordnung dargestellt und in Figur 11 eine Mikrostruktur mit periodisch angeordneten mehreckigen Strukturelementen 3. Die Spaltbreite beträgt 3 bis 7 µm, vorzugsweise um die 5 µm. Aus den Figuren geht auch hervor, dass die Breite b der Vertiefungen oder Erhöhungen 2 immer kleiner ist als die Ausdehnung I, I' der benachbarten Strukturelemente 3.

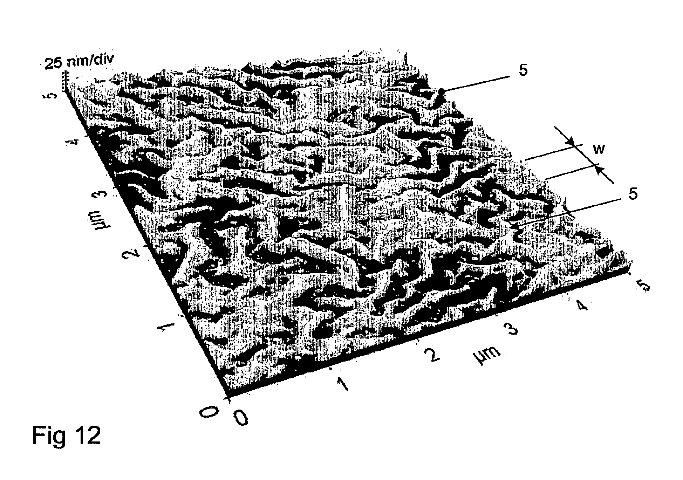

Bei der zweiten Variante erfolgt in einem nächsten, zweiten Schritt die Erzeugung einer Nanostruktur 5, die direkt auf der die Mikrostruktur mindestens in Teilbereichen überlagert wird und aus der Oberfläche 4 aus Kunststoff, hier aus der Substratoberfläche aus Kunststoff, mit einem mindestens zweistufigen Plasmabehandlung erzeugt wird, wie dies in der Figur 3 im Querschnitt dargestellt ist. In Figur 12 ist als Beispiel eine nanostrukturierte Oberfläche 5, 5' gezeigt mit statistisch verteilten wurmartigen Strukturen, wie sie sich aus diesem Verfahren ergibt. Die Nanostruktur 5 wird derart ausgebildet, dass die Höhe h deren Erhebungen im Bereich von 20 nm bis 120 nm eingestellt werden und die Abstände bzw. die Ausdehnung w der Erhebungen im Bereich von 40 nm bis 200 nm liegen. Nach der mechanischen Strukturierung wird das Substrat 1 in einer Vakuumkammer 20 in zwei Schritten mit einer Plasmaentladung behandelt, wobei bei einem ersten Schritt dem Plasma mindestens Sauerstoff oder Wasserstoff zugeführt wird zur chemischen Ätzung der Substratoberfläche 4 und bei dem darauf folgenden zweiten Schritt dem Plasma mindestens ein Edelgas, vorzugsweise Argon, beigefügt wird zur Ionenätzung der Substratoberfläche 4. Durch die Länge der Prozessführung und Einstellung der Prozessparameter können die vorerwähnten zu erzielenden Werte gewählt werden. Weitere Prozessschritte können sowohl vor dem ersten Schritt, oder zwischen den beiden Schritten, oder danach erfolgen wenn dies erforderlich ist, beispielsweise zur Reinigung der Oberflächen, wie beispielsweise des Substrates. Für die Substratreinigung wird nach der Grobreinigung und Feinreinigung vorzugsweise ein Plasmaprozess für die Feinstreinigung verwendet, bei dem ein inertes Gas wie Argon oder ein ätzendes Arbeitsgas wie Sauerstoff oder Wasserstoff zugeführt wird. Andere Verfahren zur Reinigung, wie Ionenätzen, sind ebenfalls möglich.

Bei einem Metallsubstrat kann die Nanostruktur ebenfalls durch einen geeigneten Plasmaprozess erfolgen oder mit einer anodischen Oxidation von metallhaltigen Oberflächen, wie in der Verüffentlichung von S. Shibuichi, T. Yamamoto, T. Onda and K. Tsujü, Journal of Colloid and Interface Science 208, 287-294 (1998) beschrieben.

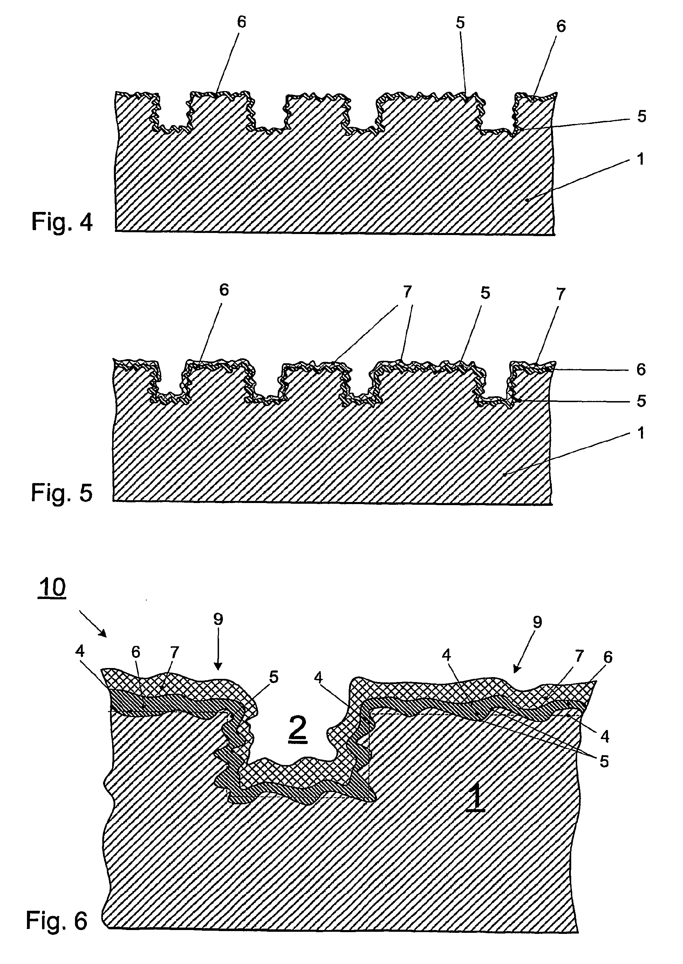

Bei den Varianten zwei und drei wird in einem nächsten Schritt, mindestens in Teilbereichen eine kohlenwasserstoffhaltige und/oder siliziumoxidhaltige Schutzschicht 6 in einer Vakuumkammer 20 aus einer Plasmaentladung auf das Substrat 1 abgeschieden, wie dies in Figur 4 dargestellt ist. Hierzu wird dem Plasma ein kohlenwasserstoffhaltiges und/oder silizium- und sauerstoffhaltiges Gas zugeführt, wobei eine Schichtdicke 6 erzeugt wird, weiche im Bereich von 2.0 bis 500 nm, vorzugsweise im Bereich von 5.0 bis 100 nm liegt. Bei transparenten, farblosen Beschichtungen beträgt die Schichtdicke 5.0 bis 50 nm. Mit dieser Schutzschicht 6 wird das Werkstück 10 vor unerwünschten Veränderungen durch schädliche Umgebungseinflüsse geschützt. Eine derartige Schutzschicht 6 wird mit Vorteil als dichtes, dreidimensional hochvernetztes plasmapolymerisiertes Gerüst, welche biegsam und weich ist oder als harte und vor mechanischen Beschädigungen (Kratzschutz, etc.) ausgebildet.

Die Schutzschicht 6 sollte mit Vorteil die Permeabilität von Sauerstoff um mindestens den Faktor 10 gegenüber dem unbeschichteten, gasdurchlässigen Substrat 1 erniedrigen. Dies ist beispielsweise messbar durch die Plasmabeschichtung einer 12 µm dicken Polyethylenterephthalat-Folie, welche eine Sauerstoff-Permeabilität weniger als 25 ml/m²xTagxbar aufweisen sollte. Die auf eine Metalloberfläche abgeschiedene mit metallhaltigen Nanopartikein dotierte plasmapolymerisierte kohlenwasserstoffhaltige Schutzschicht 6 hat einen korrosionshemmenden Effekt, der sich folgendermassen äussert: wird dieselbe Schutzschicht mit metallhaltigen Teilchen 11 dotiert, um das elektrochemische Potential des metallhaltigen Substrates zu verschieben, wird die korrosionsschützende Wirkung gegenüber einem gleichfalls beschichteten, nicht-mikrostrukturierten Substrat mindestens verdoppelt.

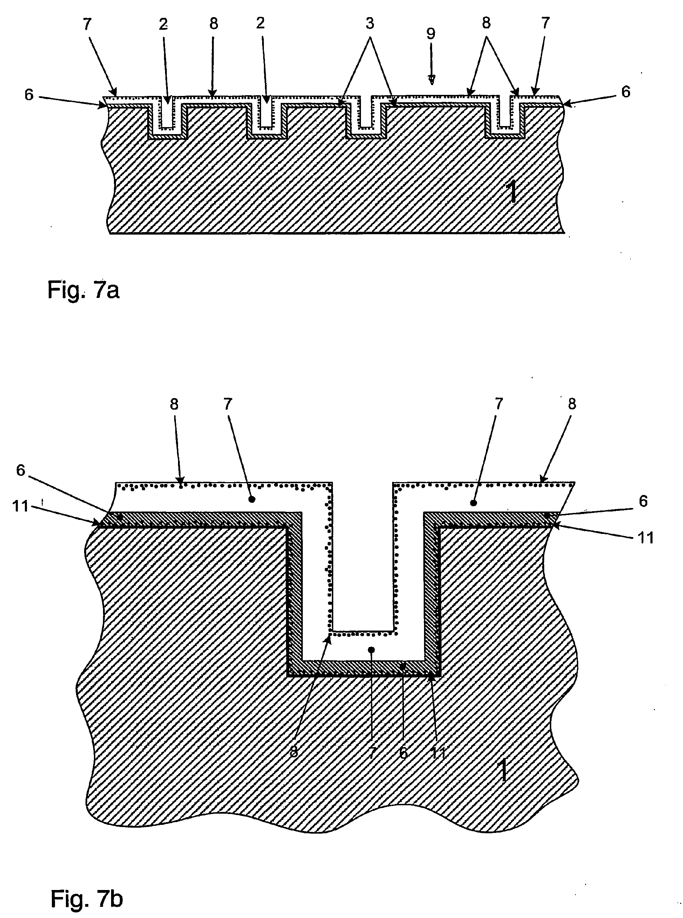

In den Figuren 6, 7a und /b ist vergrössert und im Querschnitt ein das fertig behandelte und beschichtete Werkstück 10 dargestellt mit einer mikrostrukturierten Substratoberfläche 2, 3 mit darüber liegender Schutzschicht 6 und einer abschliessenden Deckschicht 7 mit der Werkstückoberfläche 9. Diese Kombination ermöglicht nun die Herstellung von Werkstückoberflächen 9, welche gewünscht einstellbare hydrophobe Verhalten aufweisen, mit einem WCA von grösser als 90°. Für die meisten Anwendungen wird mit Vorteil ein WCA eingestellt der im Bereich von 90° bis 160° liegt, vorzugsweise im Bereich von 110° bis 160°.

In den Figuren 7a und 7b ist vergrössert und im Querschnitt das fertig behandelte und beschichtete Werkstück 10 dargestellt. Das Substrat 1 mit der mikrostrukturierten Substratoberfläche 2, 3 mit darüber liegender Schutzschicht 6 mit inkorporierten metallhaltigen Nanopartikeln 11 und darüber liegender Deckschicht 7 mit inkorporierten metallhaltigen Nanopartikeln 8.

Gemäss Variante 1 wird das Werkstück 10 mit einer keramischen metalloxidhaltigen Dünnschicht mit einer Dicke von 5.0 nm bis 500 nm ausgerüstet. Je nach Wahl der keramischen Deckschicht (TiO₂, TiOₓ(OH)_{y}, ZnO, AlOₓ, SiOₓ, ITO ((In)SnO₂) und deren Hydroxide, etc.) werden durch die metallhaltigen Nanopartikel 8, die katalytische Wirkung und/oder die elektrische Leitfähigkeit (u.a. Anti-Statik Effekt) erhöht. Metallhaltige Nanopartikel 8 (Au, Ag, Pt, Pd, Rh, Cu, Fe, Ti, Zn, etc. oder Kombinationen daraus) werden mit 5 at% bis 50 at% - vorzugsweise 5 at% bis 20 at% - an den Korngrenzen der metalloxidhaltigen Oberfläche in die äussere Oberfläche, insbesondere in die obersten Atomlagen der Deckschicht imkorporiert. Im Falle der Verwendung von beispielsweise gold- oder silberhaltigen Nanopartikeln, welche eine inhärente bakterizide Wirkung aufweisen, werden die Keime durch die freigesetzten Metall-Ionen abgetötet.

Gemäss Variante 2 wird ein mindestens an der Oberfläche polymeres Werkstück 10 mit einer Nanostruktur versehen, um die katalytische Wirkung der Deckschicht (TiO₂, ZnO, etc.) zu erhöhen, welche beispielsweise die Detoxifikation an der Werkstückoberfläche ermöglicht. Die Keime werden abgetötet und anschliessend durch die photokatalytischen Redoxreaktionen abgebaut, idealerweise in die Endprodukte Kohlendioxid und Wasser.

Wenn es erforderlich ist, können bei dieser Variante 2 ebenfalls metallhaltige Nanopartikel an der Titandioxid-Oberfläche eingebettet werden. Dies ist für viele Anwendungen im Pharma- und Medizinalbereich sinnvoll, um eine keimtötende Wirkung auch ohne Lichtexposition oder einen Anti-Statik-Effekt erreichen zu können.

Gemäss Variante 3 wird das Werkstück 10 mit einem katalytisch wirkenden Metalloxid (TiO₂, ZnO, etc.) beschichtet und an deren Oberfläche mit metallhaltigen Nanopartikeln 8 versehen.

In allen drei Varianten kann eine titanoxidhaltige Deckschicht 7 mit einer Dicke im Bereich von 5.0 nm bis 500 nm abgeschieden werden. Vorzugsweise wird eine photokatalytisch aktive Titandioxid-Schicht abgeschieden, welche eine selbstreinigende, detoxifizierende Oberfläche aufweist und zusätzlich biokompatibel ist. Falls es sich um ein organisches Substrat (Polymer, Papier) handelt, ist vor der Abscheidung der titanoxidhaltigen Deckschicht 7 die Schutzschicht 6 notwendig, um eine mögliche Degradation des Substrates zu verhindern. Im Falle eines metallischen Substrates kann die titanoxidhaltige Schicht als Schutzschicht 6 direkt auf das Substrat abgeschieden werden. Die titanoxidhaltige Schicht ist für diese selbstreinigende Funktion bei jeder Anwendung die oberste Schicht. Die photokatalytischen Eigenschaften dieser titanoxidhaltigen Deckschicht 7 werden durch die Oberflächenvergrösserung des Substrates (Mikro - und/oder Nanostrukturierung) erhöht. Bei Vorliegen der erfindungsgemäss "erzwungenen" hydrophoben Oberflächeneigenschaft wird eine organische Verunreinigung nicht nur photokatalytisch zerstört, sondern zusätzlich auch leicht abgewischt.

Bei allen Beschichtungen ist es wichtig, beispielsweise durch die Wahl der Schichtdicke darauf zu achten, dass die Mikrostruktur 2, 3 und insbesondere auch die Nanostruktur 5 an der Werkstückoberfläche 9 zumindest noch abgebildet wird, um die Funktion erfüllen zu können.

Der Einsatzbereich von Werkstücken 10 mit keimtötend wirkenden Oberflächen 9 ist äusserst weit. Vorstellbar ist die Ausrüstung von Klimaanlagen, Luftbefeuchtern, sanitären Anlagen, Schwimmbäder, Textilien- und Gebrauchsgegenstände in Spitälern, Pharmaverpackungen, Heim- und Haushaltartikel, etc.

Die Kombination mit dem hydrophoben Verhalten (Anti-Haft Effekt und gegebenenfalls auch Anti-Statik Effekt) ist wichtig für die Gewährleistung der Bewahrung der Oberflächeneigenschaften von Materialien wie Schutz vor Verunreinigung (Restverschmutzung), ökonomischen und hygienischen Aspekten (Restentleerbarkeit bei Verpackungen, Haltbarkeit von Pharmaverpackungen wie Tuben) und Oxidbildung von Metallen (Korrosion).

Das Kondensationsverhalten des Wassers, d.h. die Tropfenbildung des Wassers wird durch die Einstellung der hydrophoben Verhaltenseigenschaften auf die Verwendung des Produktes zugeschnitten. Für eine aluminiumhaltige Oberfläche in einem Wärmetauscher oder Luftbefeuchter kann die Reinigungswartung durch die Verwendung von verunreinigungsabweisenden und/oder vor Korrosion geschützten Oberflächen massiv gesenkt werden.

Bei der Verarbeitung von Materialien wie Metalle und deren Legierungen vermindert der Anti-Haft-Effekt die aufwendige Entfernung der anhaftenden Schmutzpartikel und schützt das Substrat vor Korrosion, insbesondere wenn Nanopartikel 11 am Interphase der Schutzschicht 6 das elektrochemische Potential des Substrats verschieben, um einen kathodischen oder anodischen aktiven Schutz zu erzielen.

In diesem Zusammenhang ist auch die Kombination der hydrophoben Oberfläche mit dem Diffusionsschutz vor dem Transfer von Gasen wie Sauerstoff, Stickstoff und Kohlendioxid sowie ein Migrationsschutz vor unerwünschten Zusatzstoffen aus den Verpackungen in die kontaktierende Umgebung wichtig. Ein weiterer Vorteil der erfindungsgemässen Ausarbeitung von Kunststoffoberflächen - insbesondere von Polypropylen - ist die Erhaltung der Siegelfähigkeit des Werkstückes. Gegebenenfalls kann die Erhaltung der Versiegelungseigenschaften durch Auslassung von Behandlungsschritten in diesen Teilbereichen erhöht werden.

Die vorliegende Offenbarung wird nun anschliessend anhand von weiteren Beispielen erläutert.

Beschreibung des Vorgehens für die Behandlung einer Polypropylen-Folie, welche beispielsweise 75 µm dick ist. Die einzelnen Arbeitsschritte sind in der Tabelle 1 aufgeführt.
• **1. Schritt:** Mit einer beheizbaren Prägewalze und einer Gummiwalze (Heissprägung) wird die Mikrostruktur in die Polypropylen-Folie geprägt.
• **2. Schritt:** Eine Vakuumkammer wird evakuiert, um einen Basisdruck von tiefer als ca. 10⁻² mbar als den nachfolgenden Arbeitsdruck zu erreichen. Anschliessend werden die Arbeitsgase über Massenflusskontroller in die Vakuumkammer eingelassen, der Arbeitsdruck wird mit einem Druckmessgerät kontrolliert.
Bei der zweiten Variante wird mit einem Plasmaverfahren bei Raumtemperatur eine Nanostruktur der Mikrostruktur mindestens in Teilbereichen auf das mikrostrukturierte Substrat überlagert.
1. Prozessstufe:RF-Plasma, Raumtemperatur, geerdetes Substrat
   Leistungsbereich: 200 bis 700 Watt, typischerweise bei 400 Watt
   Arbeitsdruck: ca. 1.0 x 10⁻² mbar
   Arbeitsgas: 10 bis 60 sccm Sauerstoff
   Prozesszeit: 10 bis 60 sec.
2. Prozessstufe: RF-Plasma, Raumtemperatur, geerdetes Substrat
   Leistungsbereich: 100 bis 600 Watt, typischerweise bei 300 Watt
   Arbeitsdruck: ca. 5 x 10⁻⁴ mbar
   Arbeitsgas: 10 bis 50 sccm Argon
   Prozesszeit: 10 bis 60 sec
   Prozesszeit: 10 bis 60 sec.

• **3. Schritt:** Die durch die Strukturierung vergrösserte Werkstückoberfläche wird mit einer dreidimensional hochvernetzten, plasmapolymerisierten Kohlenwasserstoffschicht bzw. DLC oder einer siliziumoxidhaltigen Schicht versehen. Die Strukturierungen werden dadurch fixiert und vor direktem Kontakt mit der Umgebung geschützt.
Beispiel für Prozessbedingungen: RF-Plasma, Raumtemperatur, Substrat geerdet, ohne oder mit Vorlegespannung

| | |
|---|---|
| Leistungsbereich: | 50 bis 400 Watt, typischerweise bei 100 Watt |
| Arbeitsdruck: | 3 × 10⁻² mbar |
| Gasgemisch: | 30 sccm C₂H₂, 15 sccm He |

• **4. Schritt:** Abscheidung einer photokatalytisch aktiven, titandioxidhaltigen Deckschicht (Anatas enthaltend) bei einer Substrattemperatur von < 80°C.
Beispiel für Prozessbedingungen: Gepulster, reaktiver DC-Magnetron Sputter Prozess mit geerdetem Substrat und variabler Magnetfeldstärke:

| | |
|---|---|
| Leistung: | 2000 Watt |
| Arbeitsdruckbereich: | 1 × 10⁻² mbar bis einige mbar, typischerweise 5 × 10⁻² mbar |
| Gasgemisch: | 35 sccm Argon und 13 sccm Sauerstoff |

• **5. Schritt:** Abscheidung von metallhaltigen Silber-Nanopartikeln mit einem Durchmesser von 3 bis 20 nm auf der photokatalytisch aktiven titanoxidhaltigen Deckschicht 7 bei einer Substrattemperatur von < 50°C.

Beispiel für Prozessbedingungen bei einem nicht bewegten Substrat und ohne Deckblende (Shutter): Gepulster DC-Magnetron Sputter Prozess mit variabler Magnetfeldstärke von einem Silber-Target und einem Substrat, das geerdet ist oder mit einer gepulsten RF-Vorlegespannung (0 bis -200 V) versehen wird.

| | |
|---|---|
| Leistung: | 10 bis 50 Watt, mit steigender und sinkender Rampe von je 0.5 sec und einem Plateau von 0.1 sec. |
| Prozesszeit: | 3 mal 1.1 sec. |
| Arbeitsdruckbereich: | 3 × 10⁻³ bis 3 × 10⁻² mbar, typischerweise 9 × 10⁻³ mbar |
| Gasgemisch: | 5 bis 15 sccm Argon und 10 bis 50 sccm Helium |

Bevorzugt ist für alle Plasmaprozesse ein Arbeitsdruckbereich von 5 x 10⁻⁴ mbar bis einige mbar, gegebenenfalls kann der Arbeitsdruck eine Atmosphäre erreichen. Die Plasmaprozesse werden bevorzugt bei Raumtemperatur durchgeführt (Substrat kann thermostatisiert, gekühlt oder leicht geheizt sein), das Werkstück ist geerdet oder mit einer gegebenenfalls - vorzugsweise gepulsten - Vorlegespannung versehen. Die Schichtdicke wird jeweils über die Behandlungszeit beziehungsweise Geschwindigkeit des Probentransfers variiert.

**Tabelle 1: Bereiche für gemessene Wasserkontaktwinkel von titandioxidhaltigen bzw. DLC-beschichteten Werkstück bestehend aus Polypropylen mit verschiedenen Mikro-Strukturelementen. Bei den titandioxidhaltig beschichteten, mikrostrukturierten Substraten sind die Werte mit und ohne Nanostrukturierung angegeben. Für die beschichtete, glatte bzw. nicht-mikrostrukturierte Werkstückoberfläche sind der Wasserkontaktwinkel und die Oberflächenenergie aufgeführt.**

| Probe | DLC mikro | TiO₂ mikro | TiO₂ mikro-nano | Beschreibung der Mikrostruktur |
|---|---|---|---|---|
| | WCA [°] | WCA [°] | WCA [°] | p: Periode, a: Abstand, d: Tiefe [µm] |
| 1 | 127.3 | 109.4 | 117.5 | Versetzte Quadrate (Erhöhungen) mit p: 28, a: 3, d: 5 |
| 2 | 124.2 | 121.2 | 113.9 | Rechtecke (Erhöhungen) mit p: 27, a: 3, d: 5 |
| 3 | v129/h109 | v 128.0 | v 114.5 | Linien mit p: 28, a: 3, d: 5 (v: vertikal, h: horizontal) |
| 4 | 136.7 | 121.3 | 109.6 | Quadrate (Vertiefungen) mit p: 20, a: 5, d: 5 |
| 5 | 126.7 | 118.9 | 116.9 | Quadrate (Erhöhungen) mit p: 28, a: 3, d: 7 |
| 6 | 130.3 | 117.3 | 110.9 | Dreiecke (Erhöhungen) mit p:25, a: 3.5, d: 5 |
| 7 | 129.1 | 101.8 | 92.9 | Pyramiden (Vertiefungen) mit p: 10, a: 5, d: 2 |
| 8 | 128.6 | 112.6 | 89.9 | Sterne (Erhöhungen) mit p: 28; d: 4.5 |
| glatt | 97.2 | 81.8 | 44.8 | Oberflächenenergie von TiO₂-Deckschicht = 37 mN/m, 49 mN/m (nanostrukturiert) |

Erläuterungen zur Tabelle: Die Wasserkontaktwinkel (WCA) wurden mit einem Kontaktwinkelmessgerät mit Verwendung der Testflüssigkeit destilliertes Wasser, gemäss den Normen ASTM D5725-95 und ASTM D724 bei 23°C und bei 50% relativer Feuchtigkeit bestimmt.

Eine mikrostrukturierte, mit einer DLC - bzw. a-C:H, oder silan-haltige a-Si/C:H - plasmabeschichtete Werkstückoberfläche ermöglicht eine stabiles, hydrophobes Verhalten mit einem WCA > 90°. Diese Werkstückoberfläche ist charakterisiert durch eine Oberflächenenergie von < 37 mN/m - gemessen auf der glatten Werkstückobertläche -, welche über einen längeren Zeitraum stabil ist. Ohne Mikrostrukturierung hat die Oberfläche einen Wasserkontaktwinkel, der je nach Deckschicht in einem grossen Bereich einstellbar ist und sich gemäss Tabelle in einem Bereich von 45 ° (TiO₂, SiO₂, etc.) befindet, wobei sich die Oberflächenenergie im Bereich von 49 mN/m (TiO₂, SiO₂, etc.) bewegt.

Wird nun eine Werkstückoberfläche nur in Teilbereichen mit der Mikrostruktur versehen, kann durch die Kombination mit der TiO₂-Deckschicht (7) folgende Situation entstehen:
- glatter Teil: hydrophiles Verhalten mit WCA < 90 °
- mikrostrukturierter Teil: hydrophobes Verhalten mit WCA > 90°

Durch die Kombination mit der Nanostruktur wird der Kontaktwinkel signifikant erniedrigt, jedoch insbesondere auf der glatten, nicht-strukturierten Werkstückoberfläche.

Eine weitere konkrete Anwendung der hydrophoben Oberfläche ist das Verhindern des Eindringens von Wasser an die Materialobertläche, das mehrere nachteilige Auswirkungen haben kann. Korrosionsverursachende Teilchen (Elektrolyte, Salze, etc.) können an die Oberfläche bzw. Grenzfläche des Grundmaterials transportiert werden und dort reagieren. Für den Korrosionsschutz ist eine schnell trocknende, hydrophobe Oberfläche von Vorteil. Die Oberfläche ist dadurch auch verunreinigungsabweisend. Die Implantation von metallhaltigen Nanopartikeln in der Schutzschicht 6 schützt zusätzlich das metallische Substrat vor Korrosion, falls das elektrochemische Potential des Substrates entsprechend modifiziert wird. Ein weiterer Vorteil ist, dass permeierende Gase und Verbindungen mit diesen metallhaltigen Nanopartikeln reagieren können und dadurch die Diffusionseigenschaften in einer Sperrschicht selektiv beeinflussen.

Die Schutzwirkung wird auch in diesem Fall durch die Kombination aus den mindestens vier möglichen Effekten der jeweiligen Anwendung angepasst: Diffusionsbarriere, elektrochemischer Effekt, hydrophobe Oberfläche und einer gegebenenfalls keimtötend wirkenden Oberfläche.

Bei den Verarbeitungsprozessen von Materialien werden die Werkstücke oftmals verunreinigt und müssen anschliessend nachgereinigt werden. Diese Restverschmutzung ist insbesondere nachteilig, wenn die Schmutzpartikel an der Werkstückobertläche gut haften. Hier ist die Einstellung des Kontaktwinkels des Werkstücks gegenüber dem verunreinigenden Medium besonders wichtig und liegt bei Metallen in einem Bereich von > 120°.

Die rasche und vollständige Entfernung von Ablagerungen auf den Materialoberflächen wird deshalb durch ein massgeschneidertes Verhalten (hydrophob oder hydrophil) optimiert. Anwendungen im Pharmabereich wie beispielsweise die Reinigung oder die Verunreinigungsabstossung von der Verpackungsaussenseite sowie die Restentleerung des Verpackungsinhaltes sind von besonderem Interesse.

## Patentansprüche

1. Verfahren zur Herstellung einer Werkstückoberfläche (9) mit vorgebbarem hydrophoben Verhalten mit einem Wasserkontaktwinkel (WCA) von grösser als 90° umfassend die folgenden Schritte:
a) es wird ein Substrat (1) verwendet, in welches mindestens in Teilbereichen mechanisch eine linienartige oder gitterartige Mikrostruktur (2, 3) mit Vertiefungen oder Erhöhungen (2) eingeprägt wird, die aus einer Vielzahl von aneinander hängenden Strukturelementen (3) gebildet wird, deren einzelne Ausdehnungen (I, I') im Bereich von 3 µm bis 50 µm liegen, und dass zwischen den angrenzenden Strukturelementen (3) grabenförmige Vertiefungen oder Erhöhungen (2) mit einer Tiefe im Bereich von 1 µm bis 10 µm ausgebildet werden, welche um die Strukturelemente (3) mit einer Breite im Bereich von 3 µm bis 11 µm angeordnet sind;
b) in einem weiteren Schritt wird mindestens eine Deckschicht (7) in einer Vakuumkammer (20) aus einer Plasmaentladung mindestens in Teilbereichen auf das Substrat (1) abgeschieden, die mindestens ein metallhaltiges und ein sauerstoffhaltiges Gas und/oder eine metalloxidhaltige Verbindung enthält und eine Schichtdicke im Bereich von 5.0 bis 500 nm aufweist.

2. Verfahren nach Anspruch 1, **dadurch gekennzeichnet, dass** über der mechanischen Mikrostrukturierung mindestens eine kohlenwasserstoffhaltige, haftvermittelnde Schutzschicht (6) in einer Vakuumkammer (20) aus einer Plasmaentladung auf das Substrat (1) mindestens in Teilbereichen abgeschieden wird, wobei der Plasmaentladung mindestens ein kohlenwasserstoffhaltiges Gas zugeführt wird, und dass eine Schichtdicke erzeugt wird, welche im Bereich von 2.0 nm bis 500 nm liegt

3. Verfahren nach Anspruch 1 oder 2, **dadurch gekennzeichnet, dass** die äussere Oberfläche (9) - insbesondere die obersten Atomlagen der Deckschicht (7) - mit mindestens einer Art von metallhaltigen Nanopartikeln (8) mit Hilfe einer Plasmabehandlung des Substrates (1) versehen ist, und dass diese eine Partikelgrösse von 1.0 bis 70 nm Durchmesser aufweisen, wobei vorzugsweise die mindestens eine Art von metallhaltigen Nanopartikel (8) aus der Reihe von Ag, Au, Pt, Pd, Rh, Cu, Fe, Zn, Ti inkorporiert werden, oder Kombinationen daraus.

4. Verfahren nach Anspruch 1 bis 3, **dadurch gekennzeichnet, dass** die Deckschicht (7) aus einem katalytisch aktiven Metalloxid aus der Reihe von TiO₂ und ZnO besteht.

5. Verfahren nach Anspruch 1 bis 4, **dadurch gekennzeichnet, dass** eine siliziumoxidhaltige Schutzschicht (6) unterhalb der Deckschicht (7) in einer Vakuumkammer (20) aus einer Plasmaentladung auf das Substrat (1) mindestens in Teilbereichen abgeschieden wird, wobei der Plasmaentladung mindestens ein siliziumhaltiges und mindestens ein sauerstoffhaltiges Gas zugeführt wird, und dass eine Schichtdicke erzeugt wird, welche im Bereich von 2.0 nm bis 500 nm liegt.

6. Verfahren nach Anspruch 1 bis 5, **dadurch gekennzeichnet, dass** die kohlenwasserstoffhaltige, haftvermittelnde Schutzschicht (6) mindestens in Teilbereichen mit mindestens einer Art von metallhaltigen Nanopartikeln (11) im Bereich von 5 bis 50 at% - vorzugsweise von 5 bis 20 at% - versehen ist.

7. Verfahren nach einem der Ansprüche 1 bis 6, **dadurch gekennzeichnet, dass** mit der Plasmabehandlung mit mindestens zwei Behandlungsschritten mindestens in Teilbereichen der Substratoberfläche (4), eine Nanostruktur (6') herausgearbeitet wird, mit den Abmessungen von 40 bis 200 nm und mit Strukturhöhen, die im Bereich von 20 bis 120 nm liegen.

8. Verfahren nach einem der Ansprüche 1 bis 7, **dadurch gekennzeichnet, dass** als Substrat (1) ein Kunststoff oder ein Metall verwendet wird, vorzugsweise ein duktiler Kunststoff, ein duktiles Metall oder ein metallisch beschichteter duktiler Kunststoff.

9. Verfahren nach einem der Ansprüche 1 bis 8, **dadurch gekennzeichnet, dass** die linienartige oder gitterartige Mikrostruktur (2, 3) aus sich periodisch wiederholenden, gleichen Strukturelementen (3) erzeugt wird, vorzugsweise durch mechanisches Einprägen.

10. Verfahren nach einem der Ansprüche 1 bis 9, **dadurch gekennzeichnet, dass** die Mikrostruktur (2, 3) durch ein Heissprägeverfahren erzeugt wird.

11. Verfahren nach einem der Ansprüche 1 bis 10, **dadurch gekennzeichnet, dass** als Kunststoff des Substrates (1) ein Thermoplast verwendet wird, vorzugsweise Polypropylen.

12. Verfahren nach einem der Ansprüche 1 bis 11, **dadurch gekennzeichnet, dass** an der behandelten Oberfläche (9) des Werkstückes (10) ein Wasserkontaktwinkel erzeugt wird, der im Bereich von 90° bis 160° liegt, vorzugsweise im Bereich von 110° bis 160°.

13. Verfahren nach einem der Ansprüche 1 bis 12, **dadurch gekennzeichnet, dass** bei der Abscheidung der Schutzschicht (6) mindestens eine metallhaltige Nanopartikel (11) inkorporiert wird, welche den Korrosionsschutz des metallhaltigen Werkstückes (10) erhöht oder die Diffusionseigenschaften von permeierenden Verbindungen beeinflusst.

14. Werkstück enthaltend ein mindestens einseitig an der Oberfläche (4) strukturiertes und beschichtetes Substrat (1), **dadurch gekennzeichnet, dass** mindestens in Teilbereichen mechanisch eine Mikrostruktur (2, 3) mit Vertiefungen oder Erhöhungen (2) eingeprägt ist, die aus einer Vielzahl von aneinander hängenden Strukturelementen (3) mit einzelnen Ausdehnungen im Bereich von 3 bis 50 µm gebildet ist, und dass zwischen den angrenzenden Strukturelementen (3) Vertiefungen oder Erhöhungen grabenförmig ausgebildet sind, welche um die Strukturelemente angeordnet sind und dass der Mikrostruktur (2, 3) mindestens in Teilbereichen eine kohlenwasserstoffhaltige oder siliziumhaltige Schutzschicht (6), mit einer Schichtdicke im Bereich von 2.0 bis 500 nm überlagert ist und dass mindestens in Teilbereichen darüber eine photokatalytisch aktive titanoxidhaltige Schicht als Deckschicht (7) angeordnet ist mit der äusseren Oberfläche (9), welche mit metallhaltigen Nanopartikeln (8) versehen ist und dass das Werkstück (10) an dieser Oberfläche (9) einen Wasserkontaktwinkel von > 90° aufweist.

15. Werkstück enthaltend ein mindestens einseitig an der Oberfläche (4) strukturiertes und beschichtetes Substrat (1), **dadurch gekennzeichnet, dass** mindestens in Teilbereichen mechanisch eine Mikrostruktur (2, 3) mit Vertiefungen oder Erhöhungen (2) eingeprägt ist, die aus einer Vielzahl von aneinander hängenden Strukturelementen (3) mit einzelnen Ausdehnungen im Bereich von 3 bis 50 µm gebildet ist, und dass zwischen den angrenzenden Strukturelementen (3) Vertiefungen oder Erhöhungen grabenförmig ausgebildet sind, welche um die Strukturelemente angeordnet sind und darüber mindestens in Teilbereichen eine mindestens eine metallhaltige Nanopartikel (11) enthaltende Schutzschicht (6) abgelegt ist, die eine Diffusionsbarriere gegenüber dem unbeschichteten Substrat (1) darstellt und dass darüber mindestens in Teilbereichen mindestens eine weitere Schicht als Deckschicht (7) angeordnet ist mit der äusseren Oberfläche (9) und dass das Werkstück an dieser Oberfläche (9) einen Wasserkontaktwinkel von > 90° aufweist.

## Claims

1. A method for producing a workpiece surface (9) having a - pre-defined hydrophobic behaviour and having a water contact angle (WCA) greater than 90°, comprising the following steps:
a) using is made of a substrate (1) into which a line-like or grid-like microstructure (2, 3) with recesses and elevations (2) is mechanically impressed at least in partial areas, said microstructure (2, 3) being formed of a plurality of structure elements (3) which are linked together and the individual extensions (I, I') of which are within a range from 3 µm to 50 µm, and that trench-shaped recesses or elevations (2) having a depth within a range from 1 µm to 10 µm are formed between the adjacent structure elements (3), said trench-shaped recesses or elevations (2) being arranged around the structure elements (3) with a width within a range from 3 µm to 11 µm.
b) in a further step, depositing at least one cover layer (7) onto the substrate (1) at least in partial areas, this being achieved from a plasma discharge in a vacuum chamber (20), said cover layer (7) containing at least one metal-containing gas and one oxygen-containing gas and/or one metal-oxide-containing compound and the cover layer (7) having a layer thickness within a range from 5.0 to 500 nm.

2. The method according to Claim 1,
**characterized in that**
at least one hydrocarbon-containing adhesion-promoting protective layer (6) is deposited onto the substrate (1) above the mechanical micro structuring at least in partial areas, this being achieved from a plasma discharge in a vacuum chamber (20), wherein at least one hydrocarbon-containing gas is supplied to the plasma discharge, and that a layer thickness being within a range from 2.0 nm to 500 nm is generated.

3. The method according to Claim 1 or 2,
**characterized in that**
the outer surface (9) - particularly the uppermost atomic layers of the cover layer (7) - is provided with at least one type of metal-containing nanoparticles (8) by means of a plasma treatment of the substrate (1) and that said nanoparticles (8) have a particle size with a diameter of 1.0 to 70 nm wherein, preferrably, the at least one type of metal-containing nanoparticles (8) is incorporated from the group of Ag, Au, Pt, Pd, Rh, Cu, Fe, Zn, Ti or combinations thereof.

4. The method according to Claims 1 to 3,
**characterized in that**
the cover layer (7) consists of a catalytically active metal oxide from the group of TiO₂ and ZnO.

5. The method according to Claims 1 to 4,
**characterized in that**
a silicon-oxide-containing protective layer (6) is deposited onto the substrate (1) below the cover layer (7) at least in partial areas, this being achieved from a plasma discharge in a vacuum chamber (20), wherein at least one silicon-containing gas and at least one oxygen-containing gas are supplied to the plasma discharge, and that a layer thickness being within a range from 2.0 nm to 500 nm is generated.

6. The method according to Claims 1 to 5,
**characterized in that**
at least in partial areas, the hydrocarbon-containing adhesion-promoting protective layer (6) is provided with at least one type of metal-containing nanoparticles (11) within a range from 5 to 50 at% - preferably from 5 to 20 at%.

7. The method according to any one of Claims 1 to 6,
**characterized in that**
by means of the plasma treatment comprising at least two treatment steps, a nanostructure (6') is worked out at least in partial areas of the substrate surface (4), having dimensions ranging from 40 to 200 nm and having structure heights being within a range from 20 to 120 nm.

8. The method according to any one of Claims 1 to 7,
**characterized in that**
a plastic or a metal is used as substrate (1), preferably a ductile plastic, a ductile metal or a metallically coated ductile plastic.

9. The method according to any one of Claims 1 to 8,
**characterized in that**
the line-like or grid-like microstructure (2, 3) is generated from periodically repeating identical structure elements (3), preferably by being impressed mechanically.

10. The method according to any one of Claims 1 to 9,
**characterized in that** the microstructure (2, 3) is generated by a hot-foil stamping method.

11. The method according to any one of Claims 1 to 10,
**characterized in that**
a thermoplastic, preferably polypropylene, is used as plastic of the substrate (1).

12. The method according to any one of Claims 1 to 11,
**characterized in that**
a water contact angle being within a range from 90° to 160°, preferably within a range from 110° to 160°, is generated on the treated surface (9) of the workpiece (10).

13. The method according to any one of Claims 1 to 12,
**characterized in that**
at least one metal-containing nanoparticle (11) which increases the corrosion protection of the metal-containing workpiece (10) or has an effect on the diffusion properties of permeating compounds is incorporated during deposition of the protective layer (6).

14. A workpiece containing a structured and coated substrate (1) at least on one side of the surface (4),
**characterized in that**
a microstructure (2, 3) with recesses and elevations (2) is mechanically impressed at least in partial areas, said microstructure (2, 3) being formed of a plurality of structure elements (3) which are linked together and have individual extensions that are within a range from 3 µm to 50 µm, and that trench-shaped recesses or elevations are formed between the adjacent structure elements (3), said trench-shaped recesses or elevations being arranged around the structure elements (3), and that a hydrocarbon-containing or silicon-containing protective layer (6) having a layer thickness within a range from 2.0 to 500 nm is superimposed on the microstructure (2, 3) at least in partial areas and that, at least in partial areas, a photocatalytically active titanium-oxide-containing layer is arranged as a cover layer (7) on top thereof, with the outer surface (9) which is provided with metal-containing nanoparticles (8), and that the workpiece (10) has a water contact angle of > 90° on this surface.

15. A workpiece containing a structured and coated substrate (1) on one side of the surface (4),
**characterized in that**
a microstructure (2, 3) with recesses and elevations (2) is mechanically impressed at least in partial areas, said microstructure (2, 3) being formed of a plurality of structure elements (3) which are linked together and have individual extensions that are within a range from 3 µm to 50 µm, and that trench-shaped recesses or elevations are formed between the adjacent structure elements (3), said trench-shaped recesses or elevations being arranged around the structure elements, and that, at least in partial areas, at least one protective layer (6) that contains metal-containing nanoparticles (11) is deposited on top thereof, said protective layer (6) representing a diffusion barrier against the uncoated substrate (1), and that at least one further layer is arranged as cover layer (7) on top thereof, with the outer surface (9), and that the workpiece has a water contact angle of > 90° on this surface (9).

## Revendications

1. Procédé de production d'une surface de pièce (9) ayant un comportement hydrophobe prédéfinissable avec un angle de contact avec l'eau (WCA) supérieur à 90° comprenant les étapes suivantes :
a) un substrat (1) est utilisé surlequel au moins par endroits une microstructure (2, 3) en forme de lignes ou de grille avec des enfoncements ou des bosses (2) est estampée mécaniquement, laquelle est formée à partir d'une pluralité d'éléments de structure (3) contigus, dont les dimensions individuelles (l, l') se trouvent dans l'intervalle de 3 µm à 50 µm, et qu'entre les éléments de structure adjacents (3) sont formés des enfoncements ou des bosses (2) en forme de tranchées ayant une profondeur dans l'intervalle de 1 µm à 10 µm, lesquels sont agencés autour des éléments de structure (3) avec une largeur dans l'intervalle de 3 µm à 11 µm ;
b) dans une autre étape, au moins une couche de recouvrement (7) est déposée au moins par endroits sur le substrat (1) dans une chambre à vide (20) à partir d'une décharge plasma, laquelle couche de recouvrement comprend au moins un gaz contenant du métal et un gaz contenant de l'oxygène et/ou un composé contenant de l'oxyde de métal et présente une épaisseur de couche dans l'intervalle de 5,0 à 500 nm.

2. Procédé selon la revendication 1,
**caractérisé en ce que**
sur la microstructure mécanique, au moins une couche de protection (6) agissant comme adhésif et contenant de l'hydrocarbure est déposée sur le substrat (1) au moins par endroits dans une chambre à vide (20) à partir d'une décharge plasma, au moins un gaz contenant de l'hydrocarbure étant introduit dans la décharge plasma, et **en ce qu'**une épaisseur de couche qui se trouve dans l'intervalle de 2,0 nm à 500 nm est générée.

3. Procédé selon la revendication 1 ou 2,
**caractérisé en ce que**
la surface extérieure (9), en particulier les positions atomiques supérieures de la couche de recouvrement (7), est pourvue d'au moins un type de nanoparticules (8) contenant du métal au moyen d'un traitement par plasma du substrat (1), et **en ce que** celles-ci présentent une taille de particule de 1,0 à 70 nm de diamètre, l'au moins un type de nanoparticules (8) contenant du métal de la série constituée d'Ag, Au, Pt, Pd, Rh, Cu, Fe, Zn, Ti ou de combinaisons de ceux-ci étant de préférence incorporé.

4. Procédé selon les revendications 1 à 3,
**caractérisé en ce que**
la couche de recouvrement (7) est constituée d'un oxyde métallique catalytiquement actif de la série constituée de TiO₂ et ZnO.

5. Procédé selon les revendications 1 à 4,
**caractérisé en ce qu'**une
couche de protection (6) contenant de l'oxyde de silicium en-dessous de la couche de recouvrement (7) est déposée sur le substrat (1) au moins par endroits dans une chambre à vide (20) à partir d'une décharge plasma, au moins un gaz contenant du silicium et au moins un gaz contenant de l'oxygène étant introduits dans la décharge plasma, et **en ce qu'**une épaisseur de couche qui se trouve dans l'intervalle de 2,0 nm à 500 nm est générée.

6. Procédé selon les revendications 1 à 5,
**caractérisé en ce que**
la couche de protection (6) agissant comme adhésif et contenant de l'hydrocarbure est pourvue au moins par endroits d'au moins un type de nanoparticules (11) contenant du métal dans l'intervalle de 5 à 50 en pourcentage atomique, de préférence de 5 à 20 en pourcentage atomique.

7. Procédé selon l'une des revendications 1 à 6,
**caractérisé en ce qu'**avec
le traitement par plasma comprenant au moins deux étapes de traitement au moins par endroits de la surface de substrat (4), une nanostructure (6□) est façonnée ayant des dimensions de 40 à 200 nm et des hauteurs de structure situées dans l'intervalle de 20 à 120 nm.

8. Procédé selon l'une des revendications 1 à 7,
**caractérisé en ce qu'**en
tant que substrat (1) une matière plastique ou un métal est utilisé(e), de préférence une matière plastique ductile, un métal ductile ou une matière plastique ductile à revêtement métallique.

9. Procédé selon l'une des revendications 1 à 8,
**caractérisé en ce que**
la microstructure (2, 3) en forme de lignes ou de grille est générée à partir d'éléments de structure (3) identiques se répétant périodiquement, de préférence par estampage mécanique.

10. Procédé selon l'une des revendications 1 à 9,
**caractérisé en ce que**
la microstructure (2, 3) est générée par un procédé d'estampage à chaud.

11. Procédé selon l'une des revendications 1 à 10,
**caractérisé en ce qu'**en
tant que matière plastique du substrat (1) un thermoplastique est utilisé, de préférence du polypropylène.

12. Procédé selon l'une des revendications 1 à 11,
**caractérisé en ce que**
sur la surface traitée (9) de la pièce (10), un angle de contact avec l'eau est généré qui est situé dans l'intervalle de 90° à 160°, de préférence dans l'intervalle de 110° à 160°.

13. Procédé selon l'une des revendications 1 à 12,
**caractérisé en ce que**
lors du dépôt de la couche de protection (6) au moins une nanoparticule contenant du métal (11) est incorporée, laquelle augmente la protection anticorrosion de la pièce contenant du métal (10) ou influence les propriétés de diffusion de composés perméants.

14. Pièce comportant un substrat (1) structuré et revêtu au moins d'un côté sur la surface (4),
**caractérisée en ce qu'**au
moins par endroits une microstructure (2, 3) avec des enfoncements et des bosses (2) est estampée mécaniquement, laquelle microstructure est formée à partir d'une pluralité d'éléments de structure (3) contigus avec des dimensions individuelles dans l'intervalle de 3 à 50 µm, et **en ce qu'**entre les éléments de structure adjacents (3) des enfoncements ou des bosses sont réalisés en forme de tranchées, lesquels sont agencés autour des éléments de structure et **en ce qu'**une couche de protection (6) contenant de l'hydrocarbure ou du silicium, avec une épaisseur de couche dans l'intervalle de 2,0 à 500 nm est superposée au moins par endroits à la microstructure (2, 3) et **en ce qu'**au moins par endroits par-dessus celle-ci une couche contenant de l'oxyde de titane photocatalytiquement active est agencée en tant que couche de recouvrement (7) avec la surface extérieure (9), laquelle est pourvue de nanoparticules (8) contenant du métal et **en ce que** la pièce (10) présente sur cette surface (9) un angle de contact avec l'eau de > 90°.

15. Pièce comportant un substrat (1) structuré et revêtu au moins d'un côté sur la surface (4),
**caractérisée en ce qu'**au
moins par endroits une microstructure (2, 3) avec des enfoncements et des bosses (2) est estampée mécaniquement, laquelle microstructure est formée à partir d'une pluralité d'éléments de structure (3) contigus avec des dimensions individuelles dans l'intervalle de 3 à 50 µm, et **en ce qu'**entre les éléments de structure adjacents (3) des enfoncements ou des bosses sont réalisés en forme de tranchées, lesquels sont agencés autour des éléments de structure et **en ce qu'**une couche de protection (6) contenant au moins une nanoparticule (11) contenant du métal est déposée par-dessus au moins par endroits, laquelle représente une barrière de diffusion par rapport au substrat (1) non revêtu et **en ce que** par-dessus celle-ci au moins par endroits au moins une autre couche est agencée en tant que couche de recouvrement (7) avec la surface extérieure (9), et **en ce que** la pièce présente sur cette surface (9) un angle de contact avec l'eau de > 90°.
